(19) **Europäisches Patentamt European Patent Office Office européen des brevets**

(11) **EP 3 892 151 B1**

(12) **FASCICULE DE BREVET EUROPEEN**

(45) Date de publication et mention de la délivrance du brevet:
**08.07.2026 Bulletin 2026/28**

(21) Numéro de dépôt: **20168211.9**

(22) Date de dépôt: **06.04.2020**

(51) Classification Internationale des Brevets (IPC):
*A44C 27/00* (2006.01)   *C23C 14/08* (2006.01)
*C23C 16/40* (2006.01)   *C23C 16/455* (2006.01)
*G04B 45/00* (2006.01)   *G04B 47/04* (2006.01)
*G04B 37/22* (2006.01)   *G04B 19/04* (2006.01)
*G04B 19/12* (2006.01)   *G04B 19/18* (2006.01)
*A44C 17/00* (2006.01)

(52) Classification Coopérative des Brevets (CPC):
**A44C 27/006; C23C 16/405; C23C 16/45525;
G04B 19/042; G04B 19/12; G04B 19/18;**
A44C 17/00

(54) **COMPOSANT HORLOGER ET PROCÉDÉ DE FABRICATION D'UN COMPOSANT HORLOGER**

UHRENKOMPONENTE UND VERFAHREN ZUR HERSTELLUNG EINER UHRENKOMPONENTE

CLOCK COMPONENT AND METHOD FOR MANUFACTURING A CLOCK COMPONENT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(43) Date de publication de la demande:
**13.10.2021 Bulletin 2021/41**

(73) Titulaire: **ROLEX SA**
**1211 Genève 26 (CH)**

(72) Inventeurs:
 • **BOCCARD, Cyriaque**
 **74140 DOUVAINE (FR)**

 • **BOUCHET, Jérôme**
 **1223 COLOGNY (CH)**
 • **DI LUNA, Pierre**
 **74140 VEIGY-FONCENEX (FR)**

(74) Mandataire: **Moinas & Savoye SARL**
**27, rue de la Croix-d'Or**
**1204 Genève (CH)**

(56) Documents cités:
**EP-A1- 3 588 203      DE-U1- 29 820 230
US-A1- 2019 271 951**

**Description**

La présente invention concerne un composant horloger ou de joaillerie comprenant un support et au moins un décor selon la revendication 1 et un procédé de fabrication du composant horloger ou de joaillerie selon la revendication 16.

Il est courant dans l'horlogerie ou la joaillerie de former un composant par l'intermédiaire d'un support sur lequel est solidarisé un décor. Un tel composant peut par exemple être une applique de montre, se présentant sous la forme d'un support en or massif sur lequel sont sertis des diamants ou des pierres précieuses.

Il est intéressant de pouvoir diversifier ces composants horlogers ou de joaillerie, notamment en modifiant leur aspect, particulièrement la couleur du support, pour offrir plusieurs possibilités d'aspects esthétiques.

Une première solution de l'état de la technique consiste à prévoir des supports variés, par exemple en utilisant des alliages différents. Une telle solution présente l'inconvénient d'un coût élevé, puisqu'il faut fabriquer, stocker et manipuler plusieurs alliages différents. De plus, la mise au point d'un nouvel alliage est un processus long et difficile, et seules certaines couleurs sont accessibles.

Une autre solution de l'état de la technique consiste à modifier l'aspect d'un support par un revêtement. Une telle solution simplifie la solution précédente, puisque le même support de base peut servir pour former plusieurs supports d'aspects différents. Toutefois, une telle solution présente un risque d'endommager le revêtement déposé sur le support lors des étapes ultérieures, notamment lors de la fixation des décors, par exemple au niveau des griffes d'un sertissage. Toute imperfection du support, même au niveau de la fixation des décors, est à proscrire. Il est alors délicat avec une telle solution de garantir avec fiabilité et robustesse la qualité de l'aspect esthétique obtenu.

En complément, il faut prendre en compte que dans tous les cas, il est souhaitable de pouvoir solidariser toutes sortes de décors sur un support pour former un composant d'horlogerie et de joaillerie, pour pouvoir proposer une multitude de résultats différents. Autrement dit, la solution de fabrication doit avantageusement être compatible avec la solidarisation d'un plus grand nombre de décors de types différents. Naturellement, il faut de plus garantir qu'aucun de ces décors ne sera endommagé lors du procédé de fabrication, pour conserver son aspect esthétique intact, pour lequel il a été choisi.

Le document US2019271951 divulgue un composant d'horlogerie ou de joaillerie selon le préambule de la revendication 1 et son procédé de fabrication selon le préambule de la revendication 16.

Ainsi, la présente invention a pour objet d'améliorer les procédés connus de fabrication d'un composant d'horlogerie ou de joaillerie comprenant un support sur lequel est solidarisé au moins un décor.

Plus précisément, l'invention a pour objet de pouvoir fabriquer un composant horloger ou de joaillerie d'aspect esthétique attractif, grâce à l'assemblage d'un décor sur un support, en permettant une grande flexibilité au niveau du choix des matériaux utilisables et des rendus esthétiques qui peuvent être obtenus, particulièrement des couleurs que peut prendre le support, et en garantissant une perfection de l'aspect esthétique obtenu.

A cet effet, l'invention repose sur un composant horloger ou de joaillerie tel que défini dans la revendication 1.

L'invention porte aussi sur une pièce d'horlogerie ou de joaillerie comprenant un tel composant horloger ou de joaillerie.

L'invention porte aussi sur un procédé de fabrication d'un composant horloger ou de joaillerie selon la revendication 16.

Des modes de réalisation préférés de l'invention sont fournis selon les revendications dépendantes.

Ces objets, caractéristiques et avantages de la présente invention seront exposés en détail dans la description suivante de modes de réalisation particuliers faits à titre non-limitatif en relation avec les figures jointes parmi lesquelles :

La figure 1 représente des composants obtenus pour différentes épaisseurs de revêtement selon un premier exemple de réalisation de l'invention.

Les figures 2 à 4 représentent les réflectances (R en %) en fonction de la longueur d'onde ($\lambda$ en nm) mesurées respectivement sur un support en or gris, en or jaune et en or rose, selon un deuxième exemple de réalisation de l'invention.

La figure 5 représente des composants obtenus selon un troisième exemple de réalisation de l'invention.

La figure 6 illustre le degré de perception du revêtement pour un revêtement d'oxyde de tantale de 47 nm déposé par la technique ALD, en fonction de la transmittance du matériau le recevant selon le troisième exemple de réalisation de l'invention.

L'invention atteint l'objet recherché de manière simple et surprenante, par l'intermédiaire d'un dépôt d'un même revêtement à la fois sur le support et sur le ou les décors d'un composant horloger ou de joaillerie selon la revendication 1, ce revêtement étant conçu pour modifier l'aspect du support sans modifier l'aspect du ou des décors.

L'invention permet ainsi d'obtenir un support dont la couleur peut être choisie parmi un large choix de possibilités, par l'intermédiaire de la combinaison entre le matériau du support et les caractéristiques du revêtement. Elle permet de plus d'éviter tout endommagement du revêtement et d'obtenir un aspect final, particulièrement la couleur perceptible, sans imperfection, puisqu'aucune intervention ultérieure complexe n'est nécessaire sur le support, du fait que les décors sont fixés sur le support avant le dépôt du revêtement. Enfin, le procédé est très simple à mettre en œuvre puisqu'il n'y a pas besoin de masquer le ou les décors avant le dépôt du revêtement. Ce dernier peut être simplement déposé sur l'entier du composant.

En remarque complémentaire, le procédé selon l'invention est de plus compatible avec toute forme tridimensionnelle, même complexe, du décor et/ou du support. Le revêtement recouvre avantageusement toute la surface du composant, y compris celle du ou des décors, en supplément de celle du support. Le revêtement est choisi de sorte à n'avoir aucun impact ou un impact négligeable sur l'aspect du ou des décors. Ainsi, l'invention repose sur l'utilisation astucieuse d'un même revêtement positionné sur un composant composé d'au moins deux parties différentes en deux matériaux différents, en exploitant deux effets différents, même opposés, dudit revêtement sur respectivement chacun des deux matériaux desdites deux parties.

Autrement dit, l'invention porte sur un procédé de fabrication d'un composant horloger ou de joaillerie selon la revendication 16.

L'invention va maintenant être décrite dans le cadre de plusieurs exemples de réalisation.

Selon un premier exemple de réalisation, le composant horloger est une applique de cadran de montre. L'applique comprend un support en or gris, de surface giclée, de sorte à ce qu'elle soit rugueuse, serti de décors. Les décors sont des diamants dont le diamètre maximal visible est de 0.65 mm. Le procédé de l'invention est mis en œuvre par le dépôt d'un revêtement en oxyde de tantale, de préférence stœchiométrique $Ta_2O_5$, sur l'intégralité de la surface du composant horloger.

Selon ce mode de réalisation, l'étape de dépôt est réalisée par la technique de dépôt de couche atomique, connue par son sigle ALD pour la dénomination anglaise de « Atomic Layer Deposition ». Cette technique utilise par exemple un précurseur gazeux TBTEMTa (t-butylimido)tris(ethylmethylamino)tantalum(V), No CAS 511292-99-2, sous une température de dépôt de 150°C.

Plusieurs variantes de réalisation sont mises en œuvre, pour respectivement plusieurs épaisseurs du revêtement d'oxyde de tantale. Les épaisseurs déposées sont comprises entre 4.5 nm et 225.0 nm. Les variantes correspondent à une succession de phases de 50 cycles de dépôt et permettent de réaliser des épaisseurs réparties régulièrement tous les 4.5 nm, dans la plage susmentionnée.

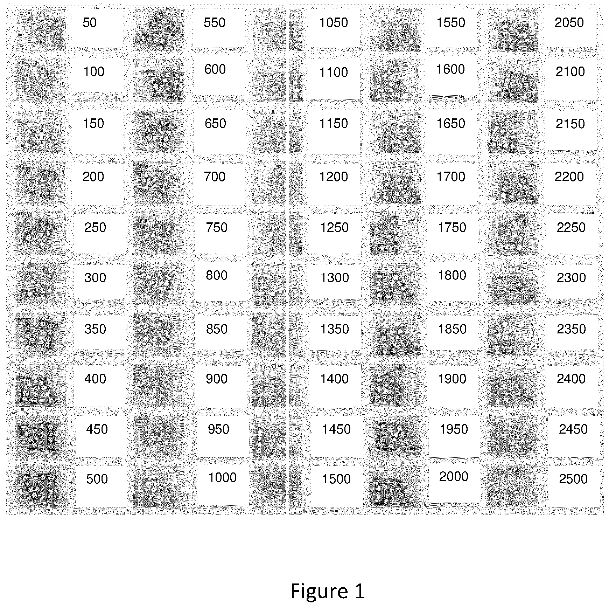

Toutes ces variantes permettent d'atteindre une coloration de l'or gris du support, selon toute une palette de couleurs qui dépend de l'épaisseur du revêtement, et donc du nombre de cycles de déposition, comme représenté par la figure 1. L'observation permet de noter que cette coloration est déjà légèrement perceptible pour une épaisseur de 4.5 nm (50 cycles), puis nettement perceptible à partir d'une épaisseur de 9 nm (100 cycles) inclus.

D'autre part, dans tous les cas, le revêtement n'induit aucune modification perceptible de l'aspect des diamants, notamment aucune modification de leur couleur, ni de leur brillance et transparence.

Pour valider ces résultats observés sur les modifications de couleur, des mesures spectrophotocolorimétriques sont pratiquées en réflexion sur des plaquettes « témoin » d'or gris identique à l'or des appliques, colorées selon l'exemple de réalisation de l'invention. Ces pièces témoin ont été réalisées pour disposer d'une superficie suffisante pour la mesure. Elles ont été produites de la même manière que les supports des appliques (même matière, même préparation de l'état de surface, même revêtement). Les mesures de réflectance sont réalisées entre 360 nm et 740 nm avec l'observateur à 2° et l'illuminant D65. La luminosité L* et les valeurs chromatiques a* et b* sont évaluées dans l'espace défini par la Commission Internationale de l'Eclairage, CIE L*a*b*, comme indiqué dans le « Technical Report of Colorimetry » CIE 15 : 2004. Les mesures sont réalisées en mode SCE (Specular Component Excluded).

Les écarts de couleur sont définis par :

$$\Delta E_{Lab}^* = \{(\Delta L^*)^2 + (\Delta a^*)^2 + (\Delta b^*)^2\}^{1/2}$$

Pour une question de simplification, $\Delta E_{Lab}^*$ est noté ΔE* dans le reste du document.

Avec :

$$\Delta L^* = L_1^* - L_0^*$$

$$\Delta a^* = a_1^* - a_0^*$$

$$\Delta b^* = b_1^* - b_0^*$$

où les indices « 1 » et « 0 » désignent deux surfaces à comparer. Dans le cas présent, l'indice « 0 » est la surface du support telle qu'elle est avant de recevoir le revêtement d'oxyde de tantale et l'indice « 1 » correspond à la même surface après avoir été revêtue par le revêtement d'oxyde de tantale par la technologie ALD, comme explicité précédemment.

Les seuils à partir desquels les modifications de couleurs sont considérées comme perceptibles sont dépendants de la couleur initiale, des conditions d'observation et de la sensibilité de la perception. De manière générale, on considère la différence de couleur comme perceptible à partir de 1 (soit $\Delta E^* \geq 1$), pour deux surfaces observées alors qu'elles sont positionnées l'une à côté de l'autre. Pour des surfaces observées consécutivement, une différence de $\Delta E^* < 3$ ou 4 peut être difficilement perceptible : le seuil peut alors se définir en fonction de différents critères. En particulier, pour des appliques de petites dimensions destinées à être positionnées sous des glaces de montre, une différence de couleur est généralement perceptible à partir de $\Delta E^*$ supérieur ou égal à 4. En résumé, la perception sera dans tous les cas nette pour $\Delta E^* \geq 4$, et même parfois pour $\Delta E^* \geq 3$, et inexistante pour $\Delta E^* < 1$.

Le relevé des mesures spectrocolorimétriques effectuées sur les témoins simulant le support selon deux variantes de ce premier exemple de réalisation est donné dans le tableau 1 ci-dessous.

*Tableau 1 : Mesures spectrocolorimétriques exprimées dans l'espace CIE L\*a\*b\* en mode SCE pour plusieurs épaisseurs de revêtements Ta$_2$O$_5$ déposées sur des pièces témoin en alliage d'or gris dont l'état de surface est rugueux (giclé).*

| Épaisseur de revêtement Ta$_2$O$_5$ [nm] (cycles) | L\*(D65) | a\*(D65) | b\*(D65) | $\Delta E^*$ |
|---|---|---|---|---|
| 0 (0) | 64.2 | 1.6 | 5.2 | 0 |
| 4.5 (50) | 63.3 | 2.0 | 7.0 | 2.0 |
| 9.0 (100) | 60.6 | 2.3 | 9.3 | 5.5 |

Ce tableau confirme que sur l'alliage d'or gris testé, la coloration est nette ($\Delta E^* = 5.5$) au-delà d'une épaisseur de 9 nm de revêtement d'oxyde de tantale, et qu'elle est légèrement perceptible pour une épaisseur de 4.5 nm ($\Delta E^* = 2$). Ces mesures confirment les observations. Cette différence de couleur peut varier avec l'augmentation de l'épaisseur du revêtement, mais reste perceptible, ou au moins légèrement perceptible, sur toute la plage testée (4.5 à 225 nm respectivement 50 à 2500 cycles).

Selon un deuxième exemple de réalisation, un revêtement d'oxyde de tantale est déposé par la technologie ALD sur des appliques comprenant respectivement un support en alliage d'or jaune, rose ou gris, en finition giclée, serties de diamants dont le diamètre maximal visible est de 0.65 mm, sans masquage des diamants durant l'étape de déposition.

Cet exemple illustre un comportement similaire, quelle que soit la composition de l'alliage d'or utilisé pour former le support : la couleur de la partie métallique formant le support du composant horloger serti varie en fonction de l'épaisseur de la couche de revêtement déposée, sans que l'aspect des diamants ne soit affecté.

Il apparaît que pour un support métallique, qui renvoie la totalité de la lumière incidente à partir de sa surface supérieure, l'effet de coloration est présent dès qu'une certaine épaisseur d'oxyde de tantale est atteinte, cette épaisseur étant dépendante de la nature chimique du support et des caractéristiques intrinsèques de la couche déposée (nature, stœchiométrie, densité, ...).

Comme précédemment, les appliques en alliage d'or jaune, rose et gris, en finition giclée, serties de diamants, sont revêtues d'oxyde de tantale avec différentes épaisseurs allant de 4.5 nm (50 cycles) à 225 nm (2500 cycles). En les observant, on note qu'elles présentent visuellement :

- Une coloration des alliages d'or constituant les supports selon toute une palette de couleurs, la coloration étant nette dès l'épaisseur de 4.5 nm de revêtement pour les alliages d'or rose et jaune, et dès 9 nm pour l'alliage d'or gris ;
- L'absence de coloration perceptible des diamants.

En complément, des mesures spectrophotocolorimétriques sont pratiquées comme pour le premier exemple précédent. Le relevé des mesures spectrocolorimétriques effectuées sur des témoins figurant les supports mentionnés précédemment est donné dans le tableau 2 ci-après. Ces résultats indiquent notamment que sur les trois alliages d'or giclés testés, la coloration est nette ($\Delta E^* \geq 5.5$) au-delà d'une épaisseur de 9 nm de revêtement d'oxyde de tantale, et est même déjà nette dès l'épaisseur de 4.5 nm pour les alliages d'or jaune et d'or rose ($\Delta E^* \geq 3.7$). La coloration est légèrement perceptible sur l'alliage d'or gris ($\Delta E^* = 2$) pour cette épaisseur de 4.5 nm. Ces mesures confirment donc les observations visuelles résumées ci-dessus.

*Tableau 2 : Mesures spectrocolorimétriques exprimées dans l'espace CIE L\*a\*b\* en mode SCE pour plusieurs épaisseurs de revêtements Ta$_2$O$_5$ déposées sur différentes natures de surfaces.*

| Support : Alliage d'or | Épaisseur de revêtement de Ta$_2$O$_5$ [nm] | L\*(D65) | a\*(D65) | b\*(D65) | ΔE\* |
|---|---|---|---|---|---|
| Gris | 0 | 64.2 | 1.6 | 5.2 | 0 |
| Gris | 4.5 | 63.3 | 2.0 | 7.0 | 2.0 |
| Gris | 9 | 60.6 | 2.3 | 9.3 | 5.5 |
| Jaune | 0 | 71.9 | 4.4 | 21.9 | 0 |
| Jaune | 4.5 | 72.7 | 5.6 | 26.9 | 5.3 |
| Jaune | 9 | 70.2 | 6.3 | 31.6 | 10.0 |
| Rose | 0 | 68.8 | 9.3 | 14.9 | 0 |
| Rose | 4.5 | 68.5 | 10.7 | 18.3 | 3.7 |
| Rose | 9 | 65.7 | 11.9 | 22.0 | 8.2 |

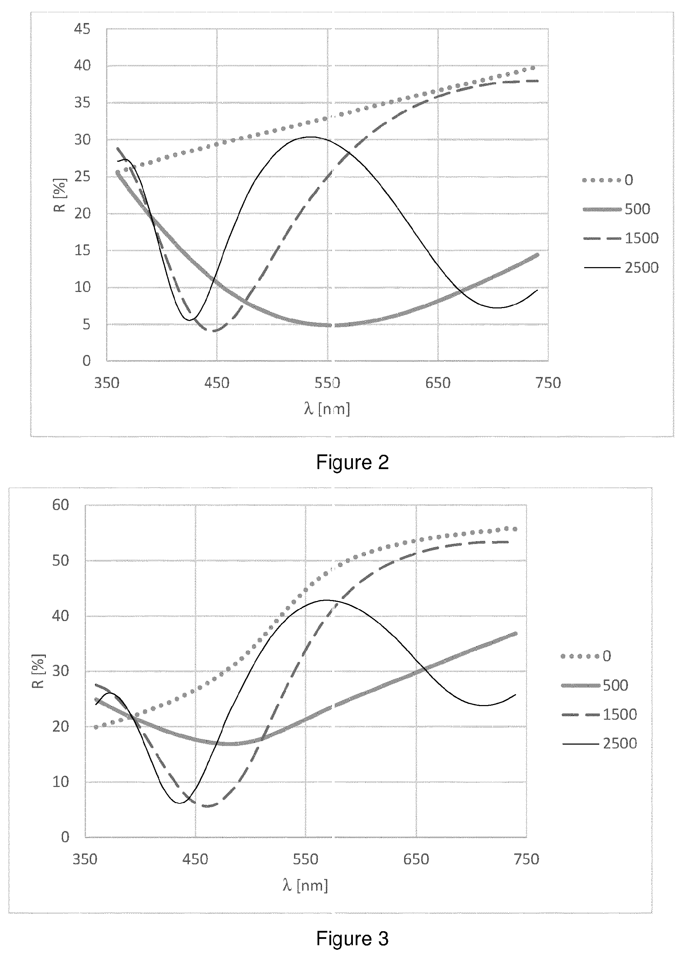

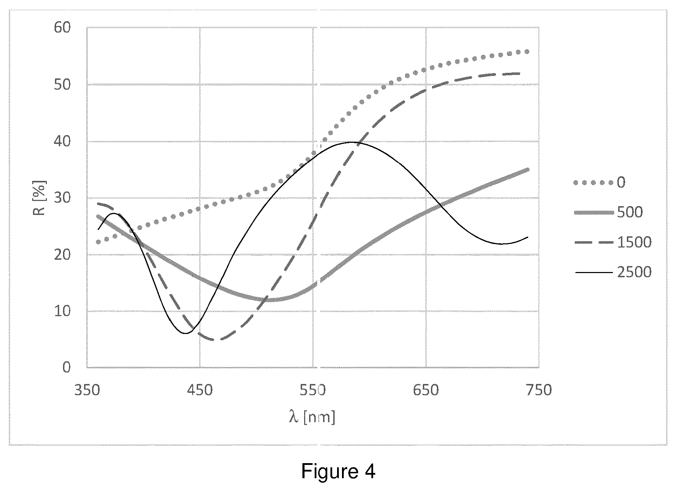

Les figures 2 à 4 illustrent les mêmes résultats, en représentant les réflectances (R en %) en fonction de la longueur d'onde (λ en nm) mesurées sur un support respectivement en or gris, en or jaune et en or rose, présentant un état de surface rugueux suite à un giclage. Sur chaque figure, plusieurs courbes correspondent respectivement à un support considéré comme référence (0 cycle de dépôt de revêtement) et sur ce même support revêtu par 500, 1500 et 2500 cycles de dépôts d'oxyde de tantale par la technique ALD (soit des épaisseurs respectives de 45 nm, 135 nm et 225 nm).

Selon un troisième exemple de réalisation, le même procédé est appliqué, en déposant différentes natures d'oxydes (oxyde de titane, oxyde d'aluminium et oxyde de tantale, ce dernier étant testé avec deux épaisseurs) sur des composants comportant différentes natures de pierres précieuses transparentes comme décors, de différentes couleurs (diamant incolore, émeraude verte, saphir bleu, rubis rouge), naturelles dans le cas présent.

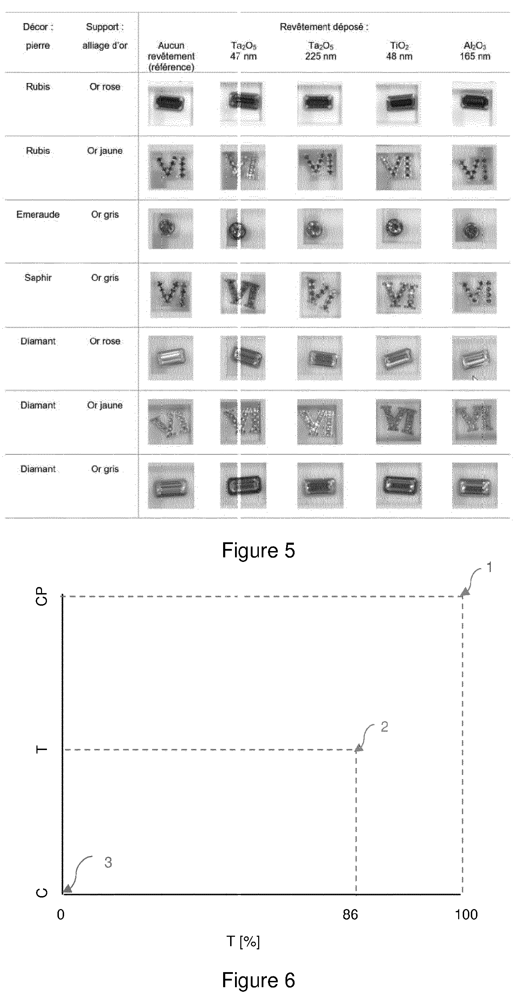

La figure 5 représente des photos dans un tableau de résultats. Il apparaît que pour une même géométrie d'applique sertie, les résultats obtenus en termes de modification de la couleur du support et d'absence de modification d'aspect des pierres précieuses dépendent de la nature chimique du revêtement déposé et de son épaisseur.

Les résultats obtenus sont aussi décrits dans les tableaux 3a et 3b ci-dessous, dans lesquels le niveau de coloration observé est indiqué par la codification suivante :

- C : colore (décrit le cas où la différence entre la couleur du support avant et après le dépôt de revêtement selon l'invention est définissable) ;
- CP : ne colore pas (décrit le cas où la différence entre la couleur du support avant et après le dépôt de revêtement selon l'invention n'est pas perceptible) ;
- T : ternit (décrit le cas intermédiaire où la différence entre l'aspect du support avant et après le dépôt de revêtement selon l'invention est perceptible, mais dont la couleur n'est pas définissable).

*Tableau 3a : Impact esthétique de différents revêtements sur différents matériaux du support.*

| Revêtement ALD vs matière du support | Ta$_2$O$_5$ 47 nm | Ta$_2$O$_5$ 225 nm | TiO$_2$ 48 nm | Al$_2$O$_3$ 165 nm |
|---|---|---|---|---|
| Or rose 18 carats | C | C | C | C |
| Or jaune 18 carats | C | C | C | C |
| Or gris 18 carats | C | C | C | C |
| Or jaune 24 carats | C | C | C | C |
| Palladium | C | C | C | C |
| Revêtement ALD vs matière du support | Ta$_2$O$_5$ 47 nm | Ta$_2$O$_5$ 225 nm | TiO$_2$ 48 nm | Al$_2$O$_3$ 165 nm |
| Silicium | C | C | C | C |

*Tableau 3b : Impact esthétique de différents revêtements sur différents matériaux du décor.*

| Revêtement ALD vs matière du décor | $Ta_2O_5$ 47 nm | $Ta_2O_5$ 225 nm | $TiO_2$ 48 nm | $Al_2O_3$ 165 nm |
|---|---|---|---|---|
| Rubis rouge (3.4 mm x 1.4 mm) | -T | ~CP | ~CP | ~CP |
| Rubis rouge (Ø 0.65 mm) | CP | CP | CP | CP |
| Émeraude verte (Ø 1.80 mm) | CP | CP | CP | CP |
| Saphir bleu (Ø 0.65 mm) | CP | CP | CP | CP |
| Diamant incolore (3.4 mm x 1.4 mm) | CP | CP | CP | CP |
| Diamant incolore (Ø 0.65 mm) | CP | CP | CP | CP |
| Alumine massive incolore (glace saphir transparente) (Ø 29 mm) | T | C | T | CP |

Les dimensions des décors indiquées sont les dimensions maximales de la partie visible du décor (diamètre ou longueur x largeur).

Les résultats montrent que pour un support opaque, tel que les métaux et les métalloïdes, la coloration par le dépôt d'un revêtement est perceptible sur toutes les configurations testées, indépendamment de la dimension du support, alors que pour un décor transparent ou semi-transparent, la perception de la coloration à couche équivalente varie en fonction de la taille et de la teinte initiale du décor. On constate que les éléments semi-transparents, tels que les diamants et autres pierres colorées, ne sont pas impactés esthétiquement de manière perceptible par le revêtement, c'est-à-dire que leur couleur n'est pas modifiée de manière perceptible, à moins que leur taille ne soit importante. Une modification de couleur est par exemple perceptible sur la surface d'une glace de montre en alumine ou sur certaines pierres de relativement grande dimension.

Les résultats précédents de ce troisième exemple illustrent qu'il peut exister dans certains cas une limite en transmittance et en dimensions pour définir si un élément sera coloré ou non par l'ajout d'un revêtement mince. Toutefois, cette limite est difficile à définir par une simple formule en raison du nombre important des paramètres impliqués, et de la géométrie particulière complexe des composants.

D'une manière générale, l'augmentation de la transmittance rend moins perceptible une coloration. De même, l'augmentation d'une surface d'un composant rend plus perceptible une coloration.

La figure 6 illustre toutefois le degré de perception du revêtement pour un revêtement d'oxyde de tantale de 47 nm déposé par la technique ALD, en fonction de la transmittance du matériau, dans le cas d'appliques comprenant des diamants 1 ayant un diamètre maximal visible de 1.4 mm, d'une glace en saphir 2 de 29 mm de diamètre ou d'un support en alliage métallique 3.

Selon un quatrième exemple de réalisation, un dépôt d'un revêtement d'épaisseur de 9.9 nm d'oxyde de tantale a été pratiqué sur un cadran émaillé en or gris. L'émail est transparent, vert clair, localisé dans des creusures pratiquées dans le cadran. Les résultats des mesures spectrocolorimétriques sont récapitulés dans le tableau 4 ci-dessous. Le revêtement a donné une coloration perceptible de l'or et quasiment imperceptible de l'émail transparent.

*Tableau 4 : Résultats de mesures spectrocolorimétriques pratiquées avec l'illuminant D65, dans l'espace CIE L\*a\*b\* en mode SCE, sur l'or gris et l'émail, avant et après le dépôt d'un revêtement de $Ta_2O_5$ de 9.9 nm d'épaisseur.*

| Emplacement de la mesure | L* | a* | b* | ΔE* |
|---|---|---|---|---|
| Émail vert | 32.46 | -39.03 | 8.70 | - |
| Émail revêtu de 9.9 nm de $Ta_2O_5$ | 34.03 | -36.69 | 8.68 | 2.82 |
| Or gris | 54.22 | 1.99 | 7.94 | - |
| Or gris revêtu de 9.9 nm de $Ta_2O_5$ | 45.71 | 2.5 | 4.92 | 9.05 |

Dans tous les cas, le support se présente comme toute partie destinée à recevoir au moins un décor. De préférence, il est composé d'un alliage d'or, notamment un alliage 18 carats d'or gris, d'or rose, d'or rouge ou d'or jaune. En variante, il peut également être composé de platine, d'un alliage à base de platine, de cuivre, d'un alliage à base de cuivre (laiton, maillechort, bronze notamment), de ruthénium, d'un alliage à base de ruthénium, de palladium, d'un alliage à base de palladium, de nickel, ou d'un alliage à base de nickel. Plus généralement, le support peut être en métal ou en alliage métallique ou en métalloïde.

En variante, tout matériau opaque pouvant faire office de support à décor est adapté. Le support présente ainsi de préférence une transmittance inférieure à 86%, voire inférieure ou égale à 50%.

D'autre part, le support peut présenter toute forme, plane ou non, incluant une forme tridimensionnelle. Il peut comprendre un dispositif de fixation tridimensionnel du au moins un décor, notamment une ou plusieurs griffes de sertissage. Le dispositif de fixation du au moins un décor peut être quelconque, dès lors qu'il permet de solidariser le décor sur le support. Ainsi, le au moins un décor peut être solidarisé au support par sertissage ou par cloisonnement.

De même, le au moins un décor est transparent. Plus précisément, selon un mode de réalisation, sa transmittance est supérieure ou égale à 86%, voire supérieure ou égale à 90%. En remarque, le décor peut être intégralement transparent (ou de forte transmittance), ou en variante transparent sur certaines zones seulement (comprenant par exemple des inclusions opaques sur certaines zones).

Le décor présente de plus avantageusement une petite dimension. Notamment, il présente une surface maximale projetée sur un plan inférieure ou égale à 8 cm$^2$, voire inférieure ou égale à 1 cm$^2$, voire inférieure ou égale à 0.5 cm$^2$ ou le au moins un décor comprend une ou plusieurs gemmes sertie(s) en relief sur le support et présentant chacune une surface maximale projetée inférieure ou égale à 18 mm$^2$, voire inférieure ou égale à 15 mm$^2$, voire inférieure ou égale à 10 mm$^2$.

A titre d'exemple, le au moins un décor peut être une gemme, naturelle ou synthétique, comme une pierre précieuse, un diamant, un saphir, un rubis, ou une émeraude, ou être une pierre fine telle une tsavorite, ou être une pierre ornementale.

En variante, le au moins un décor peut être constitué d'une zone contenant de l'émail, présentant une surface maximale projetée inférieure ou égale à 8 cm$^2$. Le décor peut ainsi être constitué d'un matériau transparent tel que l'émail, la vitro-céramique ou le verre.

Naturellement, le composant horloger ou de joaillerie peut comprendre un seul décor ou plusieurs décors solidarisés sur le même support, même éventuellement de sorte à couvrir presque toute la surface du support. A titre d'exemple, le composant horloger peut consister en un cadran entièrement serti de diamants. En variante, le composant horloger peut constituer en un cadran émaillé en cloisonné.

Comme explicité précédemment, le revêtement est choisi de sorte à apporter une couleur prédéfinie au support, tout en ne modifiant pas l'aspect d'au moins un décor, de préférence de tous les décors. Comme cela a été vu précédemment, de nombreux paramètres sont à prendre en compte pour le choix du revêtement. Parmi ces paramètres, certains sont liés au revêtement lui-même, notamment sa composition et son épaisseur. D'autres paramètres sont liés au support du composant, notamment son matériau, son état de surface et son opacité. Enfin, d'autres paramètres sont liés au décor du composant, notamment son matériau, sa transmittance, sa forme et sa dimension. L'homme du métier saura choisir le revêtement lui permettant d'atteindre l'effet esthétique recherché en appliquant le procédé selon l'invention définie par la revendication 16.

Le revêtement est un oxyde métallique, notamment de l'oxyde de tantale comme l'oxyde de tantale de stœchiométrie Ta$_2$O$_5$, ou un oxyde de titane, ou un oxyde de silicium, ou un oxyde d'aluminium, ou un oxyde d'alliage métallique, ou un nitrure, ou un oxynitrure.

De plus, le revêtement est transparent. Dans tous les cas, on note qu'une couche très fine de revêtement répond à l'objet recherché. D'autre part, cette épaisseur doit avoir une valeur minimale suffisante pour colorer un support.

Ainsi, le revêtement présente une épaisseur supérieure ou égale à 4nm et/ ou une épaisseur inférieure ou égale à 225 nm, de préférence inférieure ou égale à 100 nm, voire inférieure ou égale à 165 mm, voire inférieure ou égale à 200 nm.

Pour atteindre cet objectif, plusieurs techniques de dépôt sont possibles. Par exemple, le revêtement peut être déposé par une méthode de dépôt physique en phase vapeur, connue par son sigle PVD pour la dénomination anglaise de « Physical Vapor Deposition », ou par une méthode de dépôt chimique en phase vapeur, connue par son sigle CVD pour la dénomination anglaise de « Chemical Vapor Deposition », ou par une méthode de dépôt de couche atomique, connue par son sigle ALD pour la dénomination anglaise de « Atomic Layer Deposition », ou par un procédé sol-gel, ou par une méthode de dépôt par ablation laser PLD ou par monocouches auto-assemblées, méthode connue par son sigle SAM pour la dénomination anglaise de « Self-Assembled Monolayer ».

De préférence, le revêtement est déposé de manière uniforme et homogène, à épaisseur constante, sur la au moins une partie du support et la au moins une partie du décor. Il est aussi de préférence conforme à la au moins une partie du support et la au moins une partie du décor, c'est-à-dire qu'il recouvre toutes les surfaces du support et du ou des décors du composant, dans le respect de la géométrie tridimensionnelle éventuellement complexe ainsi que des états de surface du composant.

La technique de dépôt ALD sera généralement préférée car elle présente plusieurs avantages relativement aux autres techniques, parmi lesquels la possibilité de garantir la conformité mentionnée ci-dessus du revêtement, même pour un composant de forme tridimensionnelle, éventuellement complexe, notamment du fait qu'elle n'est pas directionnelle, et parmi lesquels la possibilité d'atteindre une large plage d'épaisseurs possibles, particulièrement très faibles, la nature chimique très vaste des revêtements possibles rendant de plus très large la gamme de couleurs atteignables.

Comme expliqué précédemment, la modification de couleur par le revêtement est jugée perceptible si le coefficient $\Delta E^*$ est supérieur à 1, voire supérieur à 2, voire supérieur à 3, voire supérieur à 4, et plus généralement si le coefficient $\Delta E^*$ est supérieur à un seuil compris entre 1 et 3 inclus, ou entre 1 et 4 inclus. On estime qu'il n'y a pas de modification de couleur perceptible du décor si l'écart de couleur défini par le coefficient $\Delta E^*$ est inférieur à 1. Sur de grandes surfaces, cette modification de couleur peut être mesurée pour obtenir la valeur ΔE* susmentionnée. En variante simplifiée et notamment pour de petites surfaces, elle peut être déterminée à l'œil nu par un observateur. La perception visuelle de la modification de couleur est évaluée à l'œil nu, en conditions d'éclairage par illuminant D65 et à 30 cm de distance.

L'invention porte sur un procédé de fabrication d'un composant horloger ou de joaillerie selon la revendication 16. Elle porte aussi sur une pièce d'horlogerie, comme une montre bracelet, ou une pièce de joaillerie, comprenant un composant horloger ou de joaillerie selon la revendication 1.

Le composant horloger peut être une applique, un cadran, une aiguille, un composant de mouvement ou une lunette. L'invention peut être mise en œuvre de manière élargie à tout autre composant horloger ou de joaillerie selon les revendications, constitué de deux parties au moins, dont la nature chimique diffère de manière à ce que le rendu du revêtement déposé puisse être sélectif. Par exemple, un cadran, une aiguille ou un composant de mouvement peuvent être associés à une ou des pierres précieuses. Ainsi, le composant peut notamment être un composant de mouvement en alliage de nickel phosphore NiP solidaire d'un rubis synthétique ou une ébauche de mouvement en laiton solidaire d'un ou plusieurs rubis synthétiques. De plus, lesdites deux parties du composant sont rendues solidaires par toute méthode connue de l'homme de métier, par tout dispositif de fixation. Les décors sont de préférence sertis par une opération impliquant la déformation du matériau de support. En variante, les deux parties peuvent être incrustées, coulées l'une dans l'autre.

Comme mentionné précédemment, l'invention porte aussi sur un procédé de fabrication d'un composant horloger ou de joaillerie selon la revendication 16.

La première étape consistant à se munir d'un support peut comprendre l'approvisionnement des différentes parties du composant : le support et le ou les décors.

L'étape de solidarisation du au moins un décor peut comprendre une étape de sertissage du décor, comprenant la déformation d'une partie du support, par exemple des griffes, pour coopérer avec le au moins un décor. En variante, cette étape peut comprendre une fixation par tout dispositif de fixation du support, comme une incrustation du au moins un décor, un coulage du au moins un décor dans le support, un collage, etc. En variante encore, cette étape peut comprendre le frittage d'un émail vitreux sur la surface du support ou dans une cavité préalablement pratiquée dans le support.

L'étape de dépôt d'un revêtement sur tout ou partie du support et sur tout ou partie du au moins un décor comprend avantageusement la mise en œuvre d'une technique ALD, ou en variante une méthode de dépôt physique en phase vapeur PVD, ou une méthode de dépôt chimique en phase vapeur CVD, ou une méthode de dépôt de couche atomique ALD, ou une méthode de dépôt par ablation laser PLD, ou par un procédé sol-gel, ou par monocouches auto-assemblées, méthode connue par son sigle SAM pour la dénomination anglaise de « Self-Assembled Monolayer ».

En remarque, l'étape de dépôt d'un revêtement est réalisée sans masquage d'une partie du composant, notamment sans masquage du ou des décors, ce qui rend le procédé simple à mettre en œuvre, et permet de garantir la qualité finale du revêtement, puisqu'aucune étape ultérieure, comme ce serait le cas si le décor était fixé sur le support après dépôt du revêtement, ne risque de l'endommager. Le masquage de certaines zones du composant pour des raisons techniques ou esthétiques reste possible.

La première étape consistant à se munir d'un support consiste à se munir d'un support en métal ou en alliage métallique ou en métalloïde ou en matériau opaque, notamment un alliage d'or gris, d'or rose, d'or rouge ou d'or jaune, ou en platine ou en alliage à base de platine, ou en cuivre ou en alliage à base de cuivre, en ruthénium, ou en alliage à base de ruthénium, ou en palladium, ou en alliage à base de palladium, ou en nickel, ou en alliage à base de nickel.

La première étape consistant à se munir d'un support peut consister à se munir d'un support présentant une transmittance inférieure à 86%, voire inférieure ou égale à 50%. Elle peut aussi consister à se munir d'un support présentant une forme tridimensionnelle, notamment comprenant un dispositif de fixation tridimensionnel du au moins un décor, notamment comprenant une ou plusieurs griffes de sertissage.

La deuxième étape consistant à solidariser au moins un décor consiste à solidariser au moins un décor transparent, de préférence qui présente une transmittance supérieure ou égale à 86%, voire supérieure ou égale à 90%.

Cette étape consiste soit à solidariser une ou plusieurs gemmes sertie(s) en relief sur le support et présentant chacune une surface projetée inférieure ou égale à 18 mm$^2$ ou à solidariser au moins un décor qui présente une surface maximale projetée sur un plan inférieure ou égale à 8 cm$^2$, voire inférieure ou égale à 1 cm$^2$, voire inférieure ou égale à 0.5 cm$^2$, voire inférieure ou égale à 18 mm$^2$, voire inférieure ou égale à 15 mm$^2$, voire inférieure ou égale à 10 mm$^2$.

Cette étape peut consister à solidariser au moins un décor qui est une gemme, naturelle ou synthétique, comme une pierre précieuse, un diamant, un saphir, un rubis, ou une émeraude, ou comme une pierre fine telle une tsavorite ou une pierre ornementale, ou est constitué d'un matériau transparent tel que l'émail, la vitro-céramique ou le verre.

Le au moins un décor peut être constitué d'une ou plusieurs zones contenant de l'émail, chacune desdites zones présentant une surface maximale projetée inférieure ou égale à 8 cm$^2$.

L'étape de dépôt d'un revêtement sur tout ou partie du support et sur tout ou partie du au moins un décor consiste en un dépôt d'un revêtement qui présente une épaisseur supérieure ou égale à 4 nm, et/ou une épaisseur inférieure ou égale à 225 nm, voire inférieure ou égale à 100 nm, voire inférieure ou égale à 165 mm, voire inférieure ou égale à 200 nm.

L'étape de dépôt d'un revêtement sur tout ou partie du support et sur tout ou partie du au moins un décor consiste en un dépôt d'un revêtement qui est un oxyde métallique, notamment de l'oxyde de tantale comme l'oxyde de tantale de stœchiométrie $Ta_2O_5$, ou un oxyde de titane, ou un oxyde de silicium, ou un oxyde d'aluminium, ou un oxyde d'alliage métallique, ou un oxyde de terres rares, ou un nitrure, ou un oxynitrure, ou un carbure et/ou en ce que le revêtement est transparent.

L'étape de dépôt d'un revêtement sur tout ou partie du support et sur tout ou partie du au moins un décor peut consister en un dépôt uniforme et homogène, à épaisseur constante, sur la au moins une partie du support et la au moins une partie du décor, et conforme à la au moins une partie du support et la au moins une partie du décor.

L'étape de dépôt d'un revêtement sur tout ou partie du support et sur tout ou partie du au moins un décor peut consister en un dépôt sur au moins une partie du support participant à la fixation du au moins un décor.

Enfin, le procédé peut être utilisé pour fabriquer une applique, un cadran, une aiguille, un composant de mouvement, ou une lunette.

**Revendications**

1. Composant horloger ou de joaillerie comprenant un support et au moins un décor solidarisé sur le support, où il comprend un revêtement transparent recouvrant au moins une partie du support et au moins une partie du décor, où le au moins un décor est transparent, où le au moins un décor présente une surface maximale projetée sur un plan inférieure ou égale à 8 cm$^2$ ou le au moins un décor comprend une ou plusieurs gemmes sertie(s) en relief sur le support et présentant chacune une surface projetée inférieure ou égale à 18 mm$^2$, **caractérisé en ce que** le support est un support en métal ou en alliage métallique ou en métalloïde ou en matériau opaque, notamment en or ou en un alliage d'or gris, d'or rose, d'or rouge ou d'or jaune, ou en platine ou en alliage à base de platine, ou en ruthénium, ou en alliage à base de ruthénium, ou en palladium, ou en alliage à base de palladium, ou en nickel, ou en alliage à base de nickel, ou en cuivre ou en alliage de cuivre, **en ce que** le revêtement présente une épaisseur supérieure ou égale à 4 nm et/ou une épaisseur inférieure ou égale à 225 nm, et **en ce que** le revêtement est un oxyde métallique, notamment de l'oxyde de tantale comme l'oxyde de tantale de stœchiométrie $Ta_2O_5$, ou un oxyde de titane, ou un oxyde de silicium, ou un oxyde d'aluminium, ou un oxyde d'alliage métallique, ou un oxyde de terres rares, ou un carbure, ou un nitrure, ou un oxynitrure, le revêtement modifiant la couleur perceptible du support sans modifier la couleur perceptible du au moins un décor.

2. Composant horloger ou de joaillerie selon la revendication précédente, **caractérisé en ce que** le revêtement modifie la couleur perceptible du support, c'est-à-dire selon un écart de couleur défini par un coefficient $\Delta E^*$ supérieur à 1, voire supérieur à 2, voire supérieur à 3, voire supérieur à 4, sans modifier la couleur perceptible du décor, c'est-à-dire selon un écart de couleur défini par un coefficient $\Delta E^*$ inférieur à 1.

3. Composant horloger ou de joaillerie selon la revendication 1, **caractérisé en ce que** le revêtement modifie la couleur perceptible du support de sorte que cette modification est perceptible à l'œil nu par un observateur, en conditions d'éclairage par illuminant D65 et à 30 cm de distance, et **en ce qu'**une modification de couleur du décor n'est pas perceptible par un observateur dans les mêmes conditions.

4. Composant horloger ou de joaillerie selon l'une des revendications précédentes, **caractérisé en ce que** le support présente une transmittance inférieure à 86%, voire inférieure ou égale à 50%.

5. Composant horloger ou de joaillerie selon l'une des revendications précédentes, **caractérisé en ce que** le support présente une forme tridimensionnelle, comprenant un dispositif de fixation tridimensionnel du au moins un décor, notamment comprenant une ou plusieurs griffes de sertissage.

6. Composant horloger ou de joaillerie selon l'une des revendications précédentes, **caractérisé en ce que** le au moins un décor présente une transmittance supérieure ou égale à 86%, voire supérieure ou égale à 90%.

7. Composant horloger ou de joaillerie selon l'une des revendications précédentes, **caractérisé en ce que** le au moins un décor présente une surface maximale projetée sur un plan inférieure ou égale à 1 cm$^2$, voire inférieure ou égale à 0.5 cm$^2$, voire inférieure ou égale à 18 mm$^2$, voire inférieure ou égale à 15 mm$^2$, voire inférieure ou égale à 10 mm$^2$ ou **en ce que** le au moins un décor comprend une ou plusieurs gemmes sertie(s) en relief sur le support et présentant chacune une surface projetée inférieure ou égale à 15 mm$^2$, voire inférieure ou égale à 10 mm$^2$.

8. Composant horloger ou de joaillerie selon l'une des revendications précédentes, **caractérisé en ce que** le au moins un décor est une gemme, naturelle ou synthétique, comme une pierre précieuse, un diamant, un saphir, un rubis, ou une émeraude, ou comme une pierre fine telle une tsavorite ou une pierre ornementale, ou est constitué d'un matériau transparent tel que l'émail, la vitro-céramique ou le verre.

9.  Composant horloger ou de joaillerie selon l'une des revendications précédentes, **caractérisé en ce que** le au moins un décor est constitué d'une ou plusieurs zones contenant de l'émail, chacune desdites zones présentant une surface maximale projetée inférieure ou égale à 8 cm$^2$.

10. Composant horloger ou de joaillerie selon l'une des revendications précédentes, **caractérisé en ce que** le revêtement est déposé par une méthode de dépôt physique en phase vapeur PVD, ou par une méthode de dépôt chimique en phase vapeur CVD, ou par une méthode de dépôt de couche atomique ALD, ou par une méthode de dépôt par ablation laser PLD, ou par un procédé sol-gel, ou par monocouches auto-assemblées, méthode connue par son sigle SAM pour la dénomination anglaise de « Self-Assembled Monolayer ».

11. Composant horloger ou de joaillerie selon l'une des revendications précédentes, **caractérisé en ce que** le revêtement présente une épaisseur inférieure ou égale à 100 nm, voire inférieure ou égale à 165 mm, voire inférieure ou égale à 200 nm.

12. Composant horloger ou de joaillerie selon l'une des revendications précédentes, **caractérisé en ce que** le revêtement est déposé de manière uniforme et homogène, à épaisseur constante, sur la au moins une partie du support et la au moins une partie du décor, et conforme à la au moins une partie du support et la au moins une partie du décor.

13. Composant horloger ou de joaillerie selon l'une des revendications précédentes, **caractérisé en ce que** le au moins un décor est solidarisé au support par sertissage ou par cloisonnement et **en ce que** le revêtement est déposé au moins partiellement sur la partie du support participant à la fixation du décor.

14. Composant horloger ou de joaillerie selon l'une des revendications précédentes, **caractérisé en ce qu'**il est une applique, un cadran, une aiguille, un composant de mouvement, ou une lunette.

15. Pièce d'horlogerie ou de joaillerie, **caractérisée en ce qu'**elle comprend au moins un composant horloger ou de joaillerie selon l'une des revendications précédentes.

16. Procédé de fabrication d'un composant horloger ou de joaillerie, comprenant les étapes suivantes:

    - Se munir d'un support;
    - Solidariser au moins un décor sur ledit support pour former un composant, ledit au moins un décor étant transparent, et présentant une surface maximale projetée sur un plan inférieure ou égale à 8 cm2 ou comprenant une ou plusieurs gemmes sertie(s) en relief sur le support et présentant chacune une surface projetée inférieure ou égale à 18 mm2; et où il comprend une étape ultérieure consistant à déposer un revêtement transparent sur au moins une partie du support et sur au moins une partie du décor,

    **caractérisé en ce que** le support est un support en métal ou en alliage métallique ou en métalloïde ou en matériau opaque, notamment en or ou en un alliage d'or gris, d'or rose, d'or rouge ou d'or jaune, ou en platine ou en alliage à base de platine, ou en ruthénium, ou en alliage à base de ruthénium, ou en palladium, ou en alliage à base de palladium, ou en nickel, ou en alliage à base de nickel, ou en cuivre ou en alliage de cuivre, le revêtement présentant une épaisseur supérieure ou égale à 4 nm et/ou une épaisseur inférieure ou égale à 225 nm, et le revêtement étant un oxyde métallique, notamment de l'oxyde de tantale comme l'oxyde de tantale de stœchiométrie $Ta_2O_5$, ou un oxyde de titane, ou un oxyde de silicium, ou un oxyde d'aluminium, ou un oxyde d'alliage métallique, ou un oxyde de terres rares, ou un carbure, ou un nitrure, ou un oxynitrure, de sorte que le revêtement modifie la couleur perceptible du support sans modifier la couleur perceptible du au moins un décor.

**Patentansprüche**

1.  Uhren- oder Schmuckkomponente, umfassend einen Träger und mindestens ein auf dem Träger befestigtes Dekor, wobei sie eine transparente Beschichtung umfasst, die mindestens einen Teil des Trägers und mindestens einen Teil des Dekors bedeckt, wobei das mindestens eine Dekor transparent ist, wobei das mindestens eine Dekor eine maximale auf eine Ebene projizierte Fläche von höchstens 8 cm$^2$ aufweist oder das mindestens eine Dekor einen oder mehrere auf dem Träger in Relief gefasste(n) Edelstein(e) umfasst, die jeweils eine projizierte Fläche von höchstens 18 mm$^2$ aufweisen, **dadurch gekennzeichnet, dass** der Träger ein Träger aus Metall oder einer Metalllegierung oder einem Metalloid oder einem opaken Material ist, insbesondere aus Gold oder einer Legierung aus Weißgold, Roségold, Rotgold oder Gelbgold, oder aus Platin oder einer Platinbasislegierung, oder aus Ruthenium oder einer Rutheniumbasislegierung, oder aus Palladium oder einer Palladiumbasislegierung, oder aus Nickel oder einer Nickelbasislegierung, oder aus Kupfer oder einer Kupferlegierung, dass die Beschichtung eine Dicke von mindestens 4 nm und/oder eine Dicke von höchstens 225 nm aufweist, und dass die Beschichtung ein Metalloxid ist, insbesondere Tantaloxid wie Tantaloxid der Stöchiometrie Ta$_2$O$_5$, oder ein Titanoxid, oder ein Siliziumoxid, oder ein Aluminiumoxid, oder ein Metalllegierungsoxid, oder ein Seltenerdoxid, oder ein Carbid, oder ein Nitrid, oder ein Oxynitrid, wobei die Beschichtung die wahrnehmbare Farbe des Trägers verändert, ohne die wahrnehmbare Farbe des mindestens einen Dekors zu verändern.

2. Uhren- oder Schmuckkomponente nach dem vorhergehenden Anspruch, **dadurch gekennzeichnet, dass** die Beschichtung die wahrnehmbare Farbe des Trägers verändert, d. h. gemäß einem Farbunterschied, der durch einen Koeffizienten $\Delta E^*$ von mehr als 1, ja mehr als 2, ja mehr als 3, ja mehr als 4 definiert ist, ohne die wahrnehmbare Farbe des Dekors zu verändern, d. h. gemäß einem Farbunterschied, der durch einen Koeffizienten $\Delta E^*$ von weniger als 1 definiert ist.

3. Uhren- oder Schmuckkomponente nach Anspruch 1, **dadurch gekennzeichnet, dass** die Beschichtung die wahrnehmbare Farbe des Trägers so verändert, dass diese Veränderung für einen Beobachter mit bloßem Auge unter Beleuchtungsbedingungen mit dem Normlicht D65 und in einem Abstand von 30 cm wahrnehmbar ist, und dass eine Farbveränderung des Dekors für einen Beobachter unter denselben Bedingungen nicht wahrnehmbar ist.

4. Uhren- oder Schmuckkomponente nach einem der vorhergehenden Ansprüche, **dadurch gekennzeichnet, dass** der Träger eine Transmittanz von weniger als 86 %, ja weniger als oder gleich 50 % aufweist.

5. Uhren- oder Schmuckkomponente nach einem der vorhergehenden Ansprüche, **dadurch gekennzeichnet, dass** der Träger eine dreidimensionale Form aufweist, die eine dreidimensionale Befestigungsvorrichtung für das mindestens eine Dekor umfasst, insbesondere eine oder mehrere Fasszangen.

6. Uhren- oder Schmuckkomponente nach einem der vorhergehenden Ansprüche, **dadurch gekennzeichnet, dass** das mindestens eine Dekor eine Transmittanz von mindestens 86 %, ja mindestens 90 % aufweist.

7. Uhren- oder Schmuckkomponente nach einem der vorhergehenden Ansprüche, **dadurch gekennzeichnet, dass** das mindestens eine Dekor eine maximale auf eine Ebene projizierte Fläche von höchstens 1 cm$^2$, ja höchstens 0,5 cm$^2$, ja höchstens 18 mm$^2$, ja höchstens 15 mm$^2$, ja höchstens 10 mm$^2$ aufweist, oder dass das mindestens eine Dekor einen oder mehrere auf dem Träger in Relief gefasste(n) Edelstein(e) umfasst, die jeweils eine projizierte Fläche von höchstens 15 mm$^2$, ja höchstens 10 mm$^2$ aufweisen.

8. Uhren- oder Schmuckkomponente nach einem der vorhergehenden Ansprüche, **dadurch gekennzeichnet, dass** das mindestens eine Dekor ein Edelstein, natürlich oder synthetisch, wie ein Schmuckstein, ein Diamant, ein Saphir, ein Rubin oder ein Smaragd ist, oder wie ein Halbedelstein wie ein Tsavorit oder ein Zierstein, oder aus einem transparenten Material wie Email, Glaskeramik oder Glas besteht.

9. Uhren- oder Schmuckkomponente nach einem der vorhergehenden Ansprüche, **dadurch gekennzeichnet, dass** das mindestens eine Dekor aus einem oder mehreren emailhaltigen Bereichen besteht, wobei jeder dieser Bereiche eine maximale projizierte Fläche von höchstens 8 cm$^2$ aufweist.

10. Uhren- oder Schmuckkomponente nach einem der vorhergehenden Ansprüche, **dadurch gekennzeichnet, dass** die Beschichtung durch ein physikalisches Gasphasenabscheidungsverfahren (PVD), oder durch ein chemisches Gasphasenabscheidungsverfahren (CVD), oder durch ein Atomlagenabscheidungsverfahren (ALD), oder durch ein gepulstes Laserablationsverfahren (PLD), oder durch ein Sol-Gel-Verfahren, oder durch selbstorganisierende Monolagen (SAM) abgeschieden wird.

11. Uhren- oder Schmuckkomponente nach einem der vorhergehenden Ansprüche, **dadurch gekennzeichnet, dass** die Beschichtung eine Dicke von höchstens 100 nm, ja höchstens 165 mm, ja höchstens 200 nm aufweist.

**12.** Uhren- oder Schmuckkomponente nach einem der vorhergehenden Ansprüche, **dadurch gekennzeichnet, dass** die Beschichtung gleichmäßig und homogen bei konstanter Dicke auf dem mindestens einen Teil des Trägers und dem mindestens einen Teil des Dekors abgeschieden ist und dem mindestens einen Teil des Trägers und dem mindestens einen Teil des Dekors konform folgt.

**13.** Uhren- oder Schmuckkomponente nach einem der vorhergehenden Ansprüche, **dadurch gekennzeichnet, dass** das mindestens eine Dekor durch Fassen oder durch Cloisonné auf dem Träger befestigt ist und dass die Beschichtung mindestens teilweise auf dem an der Befestigung des Dekors beteiligten Teil des Trägers abgeschieden ist.

**14.** Uhren- oder Schmuckkomponente nach einem der vorhergehenden Ansprüche, **dadurch gekennzeichnet, dass** sie ein Applikationsstück, ein Zifferblatt, einen Zeiger, ein Uhrwerkteil oder eine Lünette ist.

**15.** Uhr oder Schmuckstück, **dadurch gekennzeichnet, dass** es mindestens eine Uhren- oder Schmuckkomponente nach einem der vorhergehenden Ansprüche umfasst.

**16.** Verfahren zur Herstellung einer Uhren- oder Schmuckkomponente, umfassend die folgenden Schritte:

- Bereitstellen eines Trägers;
- Befestigen mindestens eines Dekors auf dem genannten Träger zur Bildung einer Komponente, wobei das mindestens eine Dekor transparent ist und eine maximale auf eine Ebene projizierte Fläche von höchstens 8 cm$^2$ aufweist oder einen oder mehrere auf dem Träger in Relief gefasste(n) Edelstein(e) umfasst, die jeweils eine projizierte Fläche von höchstens 18 mm$^2$ aufweisen;
und umfasst einen anschließenden Schritt, der darin besteht, eine transparente Beschichtung auf mindestens einem Teil des Trägers und auf mindestens einem Teil des Dekors abzuscheiden,
**dadurch gekennzeichnet, dass** der Träger ein Träger aus Metall oder einer Metalllegierung oder einem Metalloid oder einem opaken Material ist, insbesondere aus Gold oder einer Legierung aus Weißgold, Roségold, Rotgold oder Gelbgold, oder aus Platin oder einer Platinbasislegierung, oder aus Ruthenium oder einer Rutheniumbasislegierung, oder aus Palladium oder einer Palladiumbasislegierung, oder aus Nickel oder einer Nickelbasislegierung, oder aus Kupfer oder einer Kupferlegierung, wobei die Beschichtung eine Dicke von mindestens 4 nm und/oder eine Dicke von höchstens 225 nm aufweist, und wobei die Beschichtung ein Metalloxid ist, insbesondere Tantaloxid wie Tantaloxid der Stöchiometrie Ta$_2$O$_5$, oder ein Titanoxid, oder ein Siliziumoxid, oder ein Aluminiumoxid, oder ein Metalllegierungsoxid, oder ein Seltenerdoxid, oder ein Carbid, oder ein Nitrid, oder ein Oxynitrid, so dass die Beschichtung die wahrnehmbare Farbe des Trägers verändert, ohne die wahrnehmbare Farbe des mindestens einen Dekors zu verändern.

**Claims**

**1.** A timepiece or jewelry component comprising a substrate and at least one decoration joined to the substrate, wherein it comprises a transparent coating covering at least one part of the substrate and at least one part of the decoration, wherein the at least one decoration is transparent, wherein the at least one decoration has a maximum surface area projected onto a plane of less than or equal to 8 cm$^2$ or the at least one decoration comprises one or more gems set in relief on the substrate and each having a projected surface area less than or equal to 18 mm$^2$, **characterized in that** the substrate is a substrate made of metal or metal alloy or metalloid or opaque material, in particular gold or an alloy of white gold, pink gold, red gold or yellow gold, or platinum or a platinum-based alloy, or ruthenium, or a ruthenium-based alloy, or palladium, or a palladium-based alloy, or nickel, or a nickel-based alloy, or copper or a copper alloy, **in that** the coating has a thickness greater than or equal to 4 nm and/or a thickness less than or equal to 225 nm, and **in that** the coating is a metal oxide, in particular tantalum oxide such as tantalum oxide of stoichiometry Ta$_2$O$_5$, or a titanium oxide, or a silicon oxide, or an aluminum oxide, or a metal alloy oxide, or a rare-earth oxide, or a carbide, or a nitride, or an oxynitride, the coating changing the perceptible color of the substrate without changing the perceptible color of the at least one decoration.

**2.** The timepiece or jewelry component as claimed in the preceding claim, **characterized in that** the coating changes the perceptible color of the substrate, i.e., according to a color difference defined by a coefficient $\Delta E^*$ greater than 1, or even greater than 2, or even greater than 3, or even greater than 4, without changing the perceptible color of the decoration, i.e., according to a color difference defined by a coefficient $\Delta E^*$ less than 1.

3. The timepiece or jewelry component as claimed in claim 1, **characterized in that** the coating changes the perceptible color of the substrate so that this change is perceptible to the naked eye by an observer, under illuminant D65 lighting conditions and at 30 cm distance, and **in that** a change in the color of the decoration is not perceptible by an observer under the same conditions.

4. The timepiece or jewelry component as claimed in one of the preceding claims, **characterized in that** the substrate has a transmittance of less than 86%, or even less than or equal to 50%.

5. The timepiece or jewelry component as claimed in one of the preceding claims, **characterized in that** the substrate has a three-dimensional shape, comprising a three-dimensional attachment device for the at least one decoration, in particular comprising one or more crimping claws.

6. The timepiece or jewelry component as claimed in one of the preceding claims, **characterized in that** the at least one decoration has a transmittance greater than or equal to 86%, or even greater than or equal to 90%.

7. The timepiece or jewelry component as claimed in one of the preceding claims, **characterized in that** the at least one decoration has a maximum surface area projected onto a plane of less than or equal to 1 $cm^2$, or even less than or equal to 0.5 $cm^2$, or even less than or equal to 18 $mm^2$, or even less than or equal to 15 $mm^2$, or even less than or equal to 10 $mm^2$, or **in that** the at least one decoration comprises one or more gems set in relief on the substrate and each having a projected surface area less than or equal to 15 $mm^2$, or even less than or equal to 10 $mm^2$.

8. The timepiece or jewelry component as claimed in one of the preceding claims, **characterized in that** the at least one decoration is a gem, natural or synthetic, such as a gemstone, a diamond, a sapphire, a ruby, or an emerald, or such as a fine stone such as a tsavorite or an ornamental stone, or consists of a transparent material such as enamel, glass-ceramic or glass.

9. The timepiece or jewelry component as claimed in one of the preceding claims, **characterized in that** the at least one decoration is constituted by one or more enamel-containing areas, each of said areas having a maximum projected surface area less than or equal to 8 $cm^2$.

10. The timepiece or jewelry component as claimed in one of the preceding claims, **characterized in that** the coating is deposited by a physical vapor deposition (PVD) method, or by a chemical vapor deposition (CVD) method, or by an atomic layer deposition (ALD) method, or by a pulsed laser deposition (PLD) method, or by a sol-gel process, or by self-assembled monolayers (SAM).

11. The timepiece or jewelry component as claimed in one of the preceding claims, **characterized in that** the coating has a thickness less than or equal to 100 nm, or even less than or equal to 165 mm, or even less than or equal to 200 nm.

12. The timepiece or jewelry component as claimed in one of the preceding claims, **characterized in that** the coating is deposited uniformly and homogeneously, at constant thickness, on the at least one part of the substrate and the at least one part of the decoration, and conforms to the at least one part of the substrate and the at least one part of the decoration.

13. The timepiece or jewelry component as claimed in one of the preceding claims, **characterized in that** the at least one decoration is joined to the substrate by crimping or by partitioning and **in that** the coating is deposited at least partially on the part of the substrate participating in the attachment of the decoration.

14. The timepiece or jewelry component as claimed in one of the preceding claims, **characterized in that** it is an applique, a dial, a hand, a movement component, or a bezel.

15. A timepiece or jewelry piece, **characterized in that** it comprises at least one timepiece or jewelry component as claimed in one of the preceding claims.

16. A process for manufacturing a timepiece or jewelry component, comprising the following steps

   - Obtaining a substrate;
   - Joining at least one decoration to said substrate to form a component, said at least one decoration being transparent, and having a maximum surface area projected onto a plane of less than or equal to 8 $cm^2$ or

comprising one or more gems set in relief on the substrate and each having a projected surface area less than or equal to 18 mm$^2$;

and wherein it comprises a further step of depositing a transparent coating on at least one part of the substrate and on at least one part of the decoration,

**characterized in that** the substrate is a substrate made of metal or metal alloy or metalloid or opaque material, in particular gold or an alloy of white gold, pink gold, red gold or yellow gold, or platinum or a platinum-based alloy, or ruthenium, or a ruthenium-based alloy, or palladium, or a palladium-based alloy, or nickel, or a nickel-based alloy, or copper or a copper alloy, the coating having a thickness greater than or equal to 4 nm and/or a thickness less than or equal to 225 nm, and **in that** the coating is a metal oxide, in particular tantalum oxide such as tantalum oxide of stoichiometry Ta2O5, or a titanium oxide, or a silicon oxide, or an aluminum oxide, or a metal alloy oxide, or a rare-earth oxide, or a carbide, or a nitride, or an oxynitride, so that the coating changes the perceptible color of the substrate without changing the perceptible color of the at least one decoration.

| | 50 | | 550 | | 1050 | | 1550 | | 2050 |
|---|---|---|---|---|---|---|---|---|---|
| | 100 | | 600 | | 1100 | | 1600 | | 2100 |
| | 150 | | 650 | | 1150 | | 1650 | | 2150 |
| | 200 | | 700 | | 1200 | | 1700 | | 2200 |
| | 250 | | 750 | | 1250 | | 1750 | | 2250 |
| | 300 | | 800 | | 1300 | | 1800 | | 2300 |
| | 350 | | 850 | | 1350 | | 1850 | | 2350 |
| | 400 | | 900 | | 1400 | | 1900 | | 2400 |
| | 450 | | 950 | | 1450 | | 1950 | | 2450 |
| | 500 | | 1000 | | 1500 | | 2000 | | 2500 |

Figure 1

Figure 2

Figure 3

Figure 4

| Décor : | Support : | Revêtement déposé : | | | | |
|---|---|---|---|---|---|---|
| pierre | alliage d'or | Aucun revêtement (référence) | $Ta_2O_5$ 47 nm | $Ta_2O_5$ 225 nm | $TiO_2$ 48 nm | $Al_2O_3$ 165 nm |
| Rubis | Or rose | | | | | |
| Rubis | Or jaune | | | | | |
| Emeraude | Or gris | | | | | |
| Saphir | Or gris | | | | | |
| Diamant | Or rose | | | | | |
| Diamant | Or jaune | | | | | |
| Diamant | Or gris | | | | | |

Figure 5

Figure 6

## RÉFÉRENCES CITÉES DANS LA DESCRIPTION

**Documents brevets cités dans la description**

- US 2019271951 A

**Littérature non-brevet citée dans la description**

- *CHEMICAL ABSTRACTS*, 511292-99-2